# EUROPEAN PATENT APPLICATION

(11) **EP 4 564 423 A1**
(43) Date of publication of application: **04.06.2025**
(21) Application number: 23212973.4
(22) Date of filing: 29.11.2023
(51) Int. Cl.: H01L 23/482

(54) **TRANSISTOR DEVICE**

(71) Applicant: Infineon Technologies AG, 85579 Neubiberg (DE)
(72) Inventor: VÖLKEL, Matthias, 82008 Unterhaching (DE); MASER, Matthias, 80686 München (DE)
(74) Representative: Kraus & Lederer PartGmbB

(57) **Abstract**

A transistor device is provided comprising a plurality of transistor cells. Each transistor cell comprises two load electrodes (11, 12) and a control electrode (13), wherein the load electrodes (11, 12) of the transistor cells are arranged spaced apart from each other in a first direction. A first pitch (pitch a) between adjacent load electrodes (11, 12) of a first subset of pairs of the load electrodes (11, 12) is smaller than a second pitch (pitch b) between adjacent load electrodes (11, 12) of a second subset of pairs of the load electrodes (11, 12). Airgaps (15) are provided between adjacent load electrodes (11, 12) of the second subset of pairs.

## Description

### TECHNICAL FIELD

The present application relates to transistor devices.

### BACKGROUND

In some transistor device implementations, a plurality of transistor cells is coupled in parallel, wherein each transistor cell comprises two load electrodes (for example source and drain electrodes in case of field effect transistors) and a control electrode (for example gate electrode in case of field effect transistors). The load electrodes of the transistor cells are arranged spaced apart from each other in a certain direction, with control electrodes therebetween. The load electrodes may be provided in an interdigital finger-like arrangement, where the first load electrodes of the transistor cells extend from a first side towards a second side, and the second load electrodes extend from the second side towards the first side.

In such an arrangement, parasitic capacitances between the corresponding electrodes (for example drain-source capacitances, gate-drain capacitances, gate-source capacitances, source-body capacitances and drain-body capacitances) inevitably exist. Such parasitic capacitances may have a negative effect on a radio frequency behavior of the transistor device.

In order to reduce parasitic capacitances, so called airgaps may be provided between adjacent load electrodes. Such airgaps are hollow chambers formed between at least some metal layers of the electrodes. However, on the negative side, such airgaps increase the pitch, i.e., the distance needed, between the electrodes, and therefore increases the area the transistor device requires on a chip die or wafer.

### SUMMARY

According to an embodiment, a transistor device as defined in claim 1 is provided. The dependent claims define further embodiments.

According to an embodiment, a transistor device is provided, comprising:
a plurality of transistor cells, each transistor cell comprising two load electrodes and a control electrode,
wherein the load electrodes of the transistor cells are arranged spaced apart from each other in a first direction,
wherein a first pitch between adjacent load electrodes of a first subset of pairs of the load electrodes is smaller than a second pitch between adjacent load electrodes of a second subset of pairs of the load electrodes,
wherein airgaps are provided between adjacent load electrodes of the second subset of pairs.

The above summary is merely a brief overview over some embodiments and is not to be construed as limiting in any way.

### BRIEF DESCRIPTION OF THE DRAWINGS

Fig. 1A is a top view of a transistor device according to an embodiment, and Fig. 1B is a schematic cross-sectional view of a part of the embodiment of Fig. 1A.
Fig. 2 is a diagram illustrating various parasitic capacitances in a transistor device.
Figures 3A and 3B are reference examples showing conventional transistor devices.
Fig. 4 is a top view of a transistor device according to a further embodiment.
Fig. 5 is a cross-sectional view of a transistor device according to a further embodiment.

### DETAILED DESCRIPTION

In the following, various embodiments will be described in detail referring to the attached drawings. These embodiments are given by way of example only and are not to be construed as limiting. For example, embodiments show transistor devices having a number of transistor cells, and the number of transistor cells shown is merely an example, and other numbers of transistor cells may be provided.

Any directional references to the drawings (e.g. top, bottom, left, right) merely indicate directions in the drawings and to not imply any preferred direction in which the transistor devices shown and discussed are orientated in space.

Each transistor cell includes two load electrodes and a control electrode. In the embodiments described below, field effect transistors (FETs) like MOSFETS are used as examples. In this case, the control electrode corresponds to the gate electrode, and the load electrodes correspond to the source and drain electrodes. However, in other embodiments other types of transistors like bipolar junction transistors (BJTs)or insulated gate bipolar transistors (IGBTs) may be used. In case of a bipolar junction transistor, the control electrode is the base electrode, and the load electrodes are the collector and emitter electrodes. In case of an IGBT, the control electrode is the gate electrode, and the load electrodes are the collector and emitter electrodes.

In the embodiments shown, a plurality of transistor cells are coupled in parallel. This generally in some embodiments may increase the current handling capability of the transistor device, as the current is distributed among the plurality of transistor cells. This is only an example, and in other embodiments transistor cells may be coupled in series, which in some embodiments may increase the voltage handling capabilities.

Embodiments described herein include airgaps. Airgaps are hollow spaces within the transistor device, typically in a metal layer stack (alternating metal layers and dielectric layers) above a processed semiconductor wafer including semiconductor devices formed thereon and/or therein. Such metal layer stacks are typically formed in the so-called back end of line (BEOL) processing in a semiconductor manufacturing process. While the term airgap is used herein, the airgaps are not necessarily filled with air, but may also have a vacuum therein or may be filled with specific gases, like a noble gas.

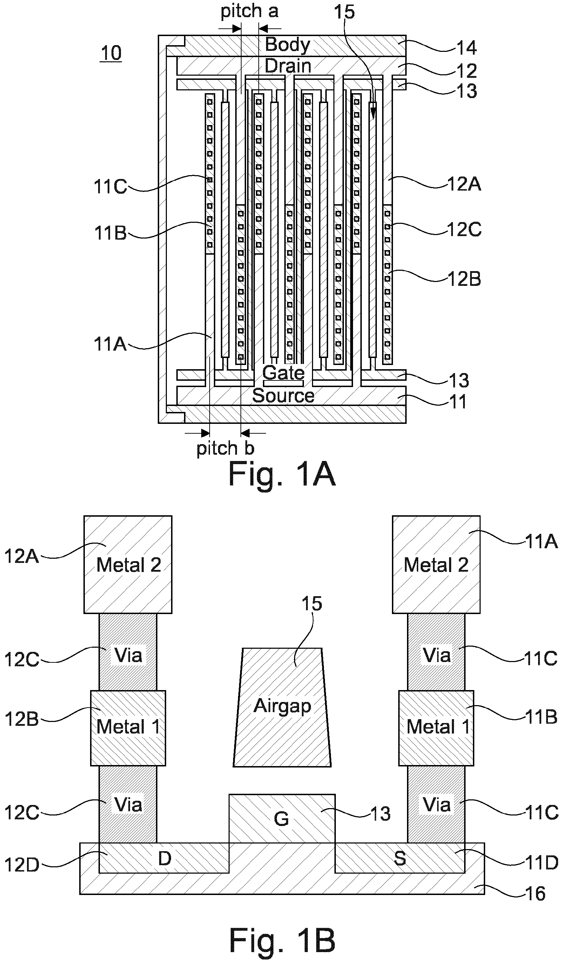

Turning now to the figures, Fig. 1A shows a top view of a transistor device 10 according to an embodiment, and Fig. 1B shows a schematic cross-sectional view of a part of the transistor device of Fig. 1A.

Transistor device 10 of Fig. 1A comprises a plurality of transistor cells coupled in parallel. Drain electrodes of the individual cells extend from a common drain 12, which effects the coupling in parallel, from a first side (top side in Fig. 1A) of transistor device 10 towards a second side (bottom side in Fig. 1A), and source electrodes extend from a common source 11 from the second side towards the first side, in an interdigital finger-like arrangement. The electrodes are spaced apart from each other in a direction perpendicular to the extension of the electrodes, from left to right in Fig. 1A. In a topmost metal layer, as shown by reference numeral 12A, the drain electrodes extend only less than halfway towards the second side, and as shown by reference numeral 11A, also in the topmost metal layer the source electrodes extend less than halfway towards the first side, such that in the topmost metal layer the drain electrodes and source electrodes are not directly adjacent to each other, which also helps to reduce parasitic capacitances.

In a lower metal layer, the electrodes extend almost to the respective other side (first side or second side), as indicated by reference numerals 11B and 12B. The metal layers are connected by vertical interconnects (vias) 11B, 11C.

A body electrode 14 for the plurality of transistor cells is also provided.

Furthermore, in the embodiment of Figures 1A and 1B, airgaps 15 are provided. As shown in Fig. 1B, an airgap 15 extends essentially in the first metal layer (11B and 12B), but not to the second, topmost, metal layer (11A and 12B). It should be noted that for the purpose of illustration, in the cross-sectional view of Fig. 1B, which shows a single transistor cell, both the source electrode and the drain electrode is shown as extending to the second metal layer, while, as shown in Fig. 1A, in some embodiments in the second metal layer (topmost metal layers) the source and drain electrodes are not immediately adjacent to each other.

As further shown in Fig. 1B, the metal layers are connected by vias 11C, 12C with a source region 11D and a drain region 12D provided in a semiconductor substrate 16.

In Fig. 1A, the airgap 15, however, is not provided between all adjacent electrodes, but only between a second subset of pairs of electrodes, which are spaced apart by a pitch b, and not between a first subset of pairs of electrodes, which are spaced apart by a pitch a smaller than a pitch b. It should be noted that in the embodiment of Fig. 1A each individual electrode (source or drain) apart from those at the periphery (leftmost and rightmost electrodes in Fig. 1A) belongs both to the first and second subset, but the pairs are different. If the electrodes are counted from left to right in Fig. 1A, the pairs of the first subset are electrode #2 and #3 (drain of the leftmost transistor cell and source of the second transistor cell from the left), electrodes #4 and #5, and electrodes #6 and #7. The pairs of the second subset are electrodes #1 and #2, electrodes #3 and #4, electrodes #5 and #6 and electrode #7 and #8. In this case, only the outermost electrodes (leftmost and rightmost in Fig. 1A) belong only to the second subset, but not to the first subset.

In some implementations, pitch a may be 500 nm and pitch b may be 600 nm, although these are only example numerical values.

By providing airgaps not between all pairs of electrodes, but only between those of the second subset, the area requirement is less than in cases where airgaps are provided between all pairs, but still a significant reduction of parasitic capacitances, in particular drain source capacitances between source and drain electrodes, can be achieved.

It should be noted that as in the topmost metal layer, (as shown by electrodes 11A and 12A) the electrodes are not immediately adjacent, it is sufficient to provide airgap 15 in the lower metal layers, metal 1 in Fig. 1A, to reduce the parasitic capacitance.

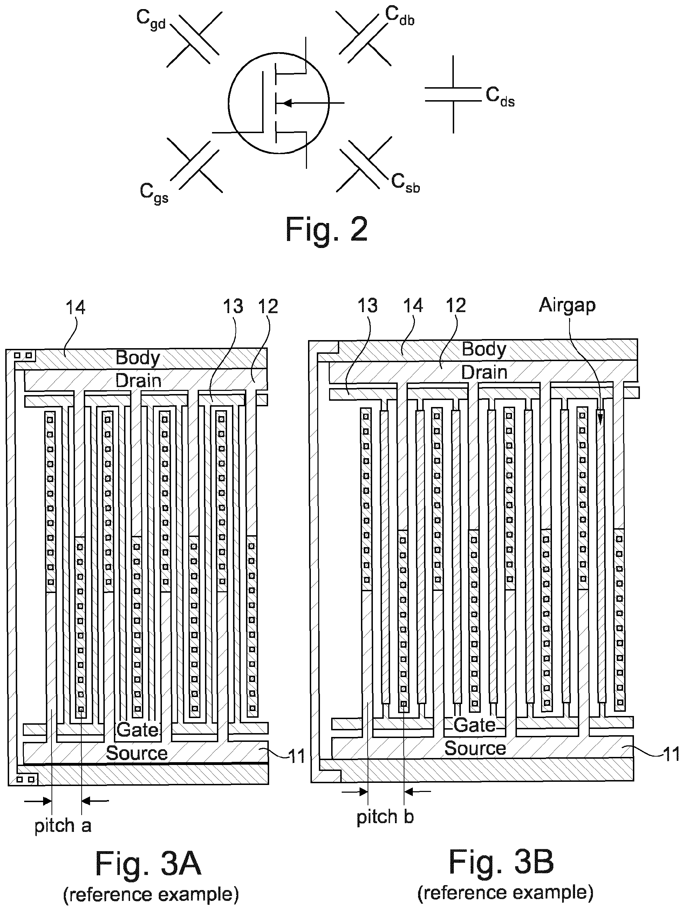

Parasitic capacitances present in transistor devices like the one of Fig. 1A and 1B are illustrated in Fig. 2. These include a drain source capacitance C_{DS}, a gate drain capacitance C_{gd}, a gate source capacitance C_{gs}, a source body capacitance (C_{sb}, and drain body capacitance C_{db}). It should be noted that not only the drain source capacitance may be reduced by the airgap, but, as the airgap is also provided for example between gate electrode 13 and the gate electrodes in the second metal layer metal 2 (11A and 12A in Fig. 1B), also the gate drain and gate source capacitances may be reduced by providing airgaps.

For further illustration, Figures 3A and 3B show reference examples. In Fig. 3A, no airgaps are provided, and pairs of adjacent electrodes are always spaced apart by pitch a. This reduces the area requirements, but increases the parasitic capacitances. In Fig. 3B, airgaps are provided between all adjacent electrodes. While this may reduce the parasitic capacitances slightly further compared to the embodiment of Fig. 1A, the area requirement is significantly increased. For example, in a particular implementation, the radio frequency performance gain between Fig. 3A and Fig. 3B may be 7%, and between Fig. 3A and Fig. 1 may still be 5%, even if only every other airgap is used.

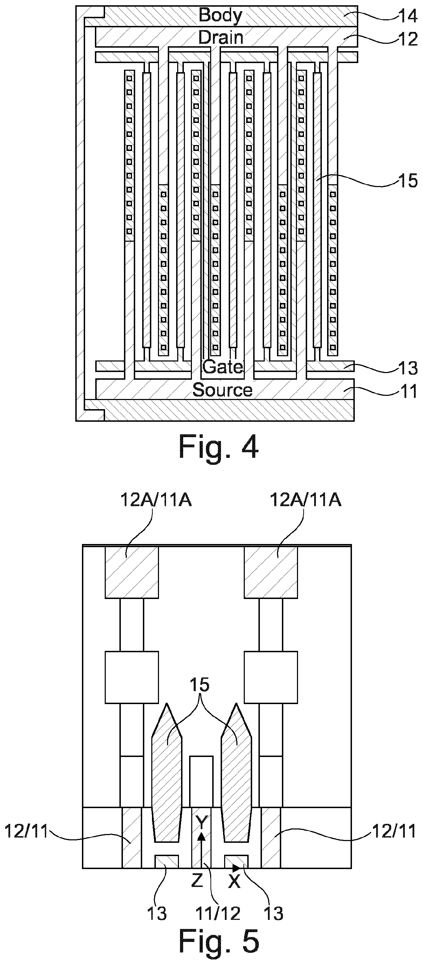

In the embodiment of Fig. 1A, airgaps are provided between half of the pairs of adjacent electrodes, i.e. alternatingly airgaps are provided or not provided between adjacent pairs. This is only an example, and other ratios between pairs where an airgap is provided and pairs where no airgap is provided are also possible. Fig. 4 shows a top view of an embodiment where airgaps are provided between two thirds of the pairs, in Fig. 4 (again from left to right) between electrodes 1# and #2, electrodes #2 and #3, electrodes #4 and #5, electrodes #5 and #6, and electrodes #7 and #8, whereas between the pairs of electrodes #3 and #4 and electrodes #6 and #7 no airgap is provided.

Also other cross-sectional forms of airgaps my be used than the one shown in Fig. 1B.

Fig. 5 shows a cross-sectional view of such an embodiment, where the designations 12/11 and 11/12 illustrate that the situation may be either between a series drain/source/drain or source/drain/source, as also the case in Fig. 4. Here, only the two outer electrodes extend to the top metal layer, whereas the middle electrode does not. Furthermore, Fig. 5 illustrates that also more than two metal layers, three metal layers in case of Fig. 5 may be provided.

Airgaps 15 in case of Fig. 5 have a form with a flat bottom (side towards the substrate) and a pointed top (side facing away from the substrate). Between the bottom and the top, a width may be wider than at the bottom. It should be noted that and airgap with such a cross-sectional form may for example also be provided in the embodiment of Figures 1A and 1B.

While the arrangement of pairs with airgaps between and pairs of load electrodes with no airgaps between is periodic, in other embodiments non-periodic arrangements may be used. Furthermore, while in the embodiments shown above the source and drain electrodes alternate in a first direction (from left to right in the figures) and extend in a second direction perpendicular thereof (from top to bottom in the top view of the figures), in other embodiments other arrangements may be provided, where at least in one metal layer the extension of the electrodes is also in the first direction. Therefore, it is evident that the embodiments discussed above are only illustrative examples.

Some embodiments are defined by the following examples:
Example 1. A transistor device, comprising:
   a plurality of transistor cells, each transistor cell comprising two load electrodes and a control electrode,
   wherein the load electrodes of the transistor cells are arranged spaced apart from each other in a first direction,
   wherein a first pitch between adjacent load electrodes of a first subset of pairs of the load electrodes is smaller than a second pitch between adjacent load electrodes of a second subset of pairs of the load electrodes,
   wherein air gaps are provided between adjacent load electrodes of the second subset of pairs.
Example 2. The transistor device of example 1, wherein the first and second load electrodes extend in a second direction perpendicular to the first direction.
Example 3. The transistor device of example 1 or 2, wherein the load electrodes of at least some of the transistor cells are provided in a plurality of metal layers, wherein metal portions of a respective load electrode of the plurality of load electrodes provided in different metal layers are electrically connected by vertical interconnects.
Example 4. The transistor device of example 3, wherein the load electrodes of the at least some of the transistor cells extend over essentially a whole length of the transistor cells in a first metal layer of the plurality of metal layers, wherein the air gaps are provided at least in the first metal layer.
Example 5. The transistor device of example 4, wherein in a topmost metal layer of the plurality of metal layers, a first one of the two load electrodes of each of the at least some of the transistor cells extends from a first side of the transistor cells over at most 50% of the length of the transistor cells, and a second one of the two load electrodes of each of the at least some of the transistor cells extends from a second side opposite the first side of the transistor cells over at most 50% of the length of the transistor cells. Example 6. The transistor device of example 5, wherein no air gaps are provided in the topmost metal layer.
Example 7. The transistor device of any one of examples 1 to 6, wherein the first pitch and the second pitch are arranged in a periodic manner.
Example 8. The transistor device of example 7, wherein the first pitch and the second pitch are arranged alternatingly.
Example 9. The transistor device of example 7, wherein each period of the arrangement in the periodic manner includes two second pitch es and one first pitch.
Example 10. The transistor device of any one of examples 1 to 9, wherein at least one of the first pitch es is arranged between two of the second pitch es.
Example 11. The transistor device of any one of example 1 to 10, wherein the first pitch is below 500nm, and the second pitch is above 500nm.
Example 12. The transistor device of any one of examples 1 to 11, wherein no airgaps are provided between adjacent load electrodes of the first subset of pairs.
Example 13. The transistor device of any one of examples 1 to 12, wherein at least one of the airgaps in cross-section has a pointed top end at a side facing away from a substrate of the transistor device.
Example 14. The transistor device of any one of examples 1 to 13, wherein at least one of the airgaps in cross-section has a straight bottom end at a side facing a substrate of the transistor device.
Example 15. The transistor device of any one of examples 1 to 14, wherein at least one of the airgaps in cross-section has a wider cross-section in a middle part that in a top part and a bottom part.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A transistor device (10), comprising:
a plurality of transistor cells, each transistor cell comprising two load electrodes (11, 12) and a control electrode (13),
wherein the load electrodes (11, 12) of the transistor cells are arranged spaced apart from each other in a first direction, wherein a first pitch (pitch a) between adjacent load electrodes (11, 12) of a first subset of pairs of the load electrodes (11, 12) is smaller than a second pitch (pitch b) between adjacent load electrodes (11, 12) of a second subset of pairs of the load electrodes (11, 12),
wherein air gaps are provided between adjacent load electrodes (11, 12) of the second subset of pairs.

2. The transistor device (10) of claim 1, wherein the first and second load electrodes (11, 12) extend in a second direction perpendicular to the first direction.

3. The transistor device (10) of claim 1 or 2, wherein the load electrodes (11, 12) of at least some of the transistor cells are provided in a plurality of metal layers, wherein metal portions of a respective load electrode of the plurality of load electrodes (11, 12) provided in different metal layers are electrically connected by vertical interconnects.

4. The transistor device (10) of claim 3, wherein the load electrodes (11, 12) of the at least some of the transistor cells extend over essentially a whole length of the transistor cells in a first metal layer of the plurality of metal layers, wherein the air gaps are provided at least in the first metal layer.

5. The transistor device (10) of claim 4, wherein in a topmost metal layer of the plurality of metal layers, a first one of the two load electrodes (11, 12) of each of the at least some of the transistor cells extends from a first side of the transistor cells over at most 50% of the length of the transistor cells, and a second one of the two load electrodes (11, 12) of each of the at least some of the transistor cells extends from a second side opposite the first side of the transistor cells over at most 50% of the length of the transistor cells.

6. The transistor device (10) of claim 5, wherein no air gaps are provided in the topmost metal layer.

7. The transistor device (10) of any one of claims 1 to 6, wherein the first pitch (pitch a) and the second pitch (pitch b) are arranged in a periodic manner.

8. The transistor device (10) of claim 7, wherein the first pitch (pitch a) and the second pitch (pitch b) are arranged alternatingly.

9. The transistor device (10) of claim 7, wherein each period of the arrangement in the periodic manner includes two second pitch (pitch b)es and one first pitch (pitch a).

10. The transistor device (10) of any one of claims 1 to 9, wherein at least one of the first pitch (pitch a)es is arranged between two of the second pitch (pitch b)es.

11. The transistor device (10) of any one of claim 1 to 10, wherein the first pitch (pitch a) is below 500nm, and the second pitch (pitch b) is above 500nm.

12. The transistor device (10) of any one of claims 1 to 11, wherein no airgaps (15) are provided between adjacent load electrodes (11, 12) of the first subset of pairs.

13. The transistor device (10) of any one of claims 1 to 12, wherein at least one of the airgaps (15) in cross-section has a pointed top end at a side facing away from a substrate (16) of the transistor device (10).

14. The transistor device (10) of any one of claims 1 to 13, wherein at least one of the airgaps (15) in cross-section has a straight bottom end at a side facing a substrate (16) of the transistor device (10).

15. The transistor device (10) of any one of claims 1 to 14, wherein at least one of the airgaps (15) in cross-section has a wider cross-section in a middle part that in a top part and a bottom part.
